(19) **Europäisches Patentamt European Patent Office Office européen des brevets**

(11) **EP 3 589 479 B1**

(12) **EUROPEAN PATENT SPECIFICATION**

(45) Date of publication and mention
of the grant of the patent:
**29.11.2023 Bulletin 2023/48**

(21) Application number: **18707059.4**

(22) Date of filing: **02.03.2018**

(51) International Patent Classification (IPC):
**B29C 64/393** (2017.01)    **B29C 64/118** (2017.01)
**B33Y 10/00** (2015.01)    **B33Y 50/02** (2015.01)
**B33Y 80/00** (2015.01)    **B29K 71/00** (2006.01)

(52) Cooperative Patent Classification (CPC):
**B29C 64/118; B29C 64/393; B33Y 10/00;
B33Y 50/02; B33Y 80/00**

(86) International application number:
**PCT/EP2018/055169**

(87) International publication number:
**WO 2018/158426 (07.09.2018 Gazette 2018/36)**

(54) **OBJECT MADE BY ADDITIVE MANUFACTURING**

ANHAND VON GENERATIVER FERTIGUNG HERGESTELLTES OBJEKT

OBJET FABRIQUÉ PAR FABRICATION ADDITIVE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **02.03.2017 NL 2018455
17.05.2017 EP 17171475**

(43) Date of publication of application:
**08.01.2020 Bulletin 2020/02**

(73) Proprietor: **Bond High Performance 3D
Technology B.V.
7521 PH Enschede (NL)**

(72) Inventors:
 • **BRUGGEMAN, Thomas Jonathan
 7521 PH Enschede (NL)**
 • **BRUGGEMAN, Adrianus
 7521 PH Enschede (NL)**
 • **KUIPER, Bouwe
 7521 PH Enschede (NL)**
 • **BARTELDS, Jan Teun
 7521 PH Enschede (NL)**
 • **KUIT, Koendert Hendrik
 7521 PH Enschede (NL)**
 • **GROEN, Klaas
 7521 PH Enschede (NL)**
 • **WOLBERS, Martijn Johannes
 7521 PH Enschede (NL)**
 • **VOSS, Kevin Hendrik Jozef
 7521 PH Enschede (NL)**

(74) Representative: **IPecunia
P.O. Box 593
6160 AN Geleen (NL)**

(56) References cited:
**WO-A1-2016/193933    WO-A2-2015/193819
US-A- 6 030 199    US-A1- 2014 141 166**

**Description**

FIELD OF THE INVENTION

The invention relates to a three-dimensional object made by additive manufacturing of a modeling material, like for example a thermoplastic polymer composition.

BACKGROUND

In additive manufacturing objects are formed by layering modeling material in a controlled manner such that a desired three dimensional shaped object can be created. Very often for additive manufacturing an additive manufacturing printer is used. The printer has a two or three dimensionally moveable printhead which dispenses the modeling material, while the printhead is moved over previously deposited tracks of the modeling material. A preferred examples of additive manufacturing is fused deposition modeling (FDM).

The object to be printed can be placed on a base. The printhead is movable in a three dimensional space relative to the object being modeled or printed or vice versa. In some cases, the object is movable in one or more dimensions relative to the printhead. Various combinations are possible for moving the object on which the object is modeled relative to the printhead and vice versa.

The motions of the printhead and optionally base are controlled by a control system which controls a controllable positioning system to which the printhead (and optionally base) is attached. By means of software a pattern of tracks can be designed, which pattern is used for moving the printhead and for depositing the tracks.

The object is created on a base structure in a reference location relative to the movable printhead. The modeling material can be fused with previously formed tracks. The additive manufacturing material can be fed in the printhead in the form of for example filaments, granulate, rods, liquid or a suspension. The printhead dispenses the modeling material from the printhead through a nozzle and deposits it on the base in the form of tracks forming a layer of tracks, or when a previous layer of the object to be created has been deposited, on the object on previously deposited tracks where it is allowed to solidify. The modeling material can be thermally or chemically or otherwise fused with the previously deposited tracks. The chemically modeling material can be dispensed from the printhead and deposited on the previously deposited tracks and cured to solidify immediately after the deposition.

The relative motion of the base and object to the printhead in tracks and simultaneous deposition of modeling material from the printhead allow the fused deposition modeled object to grow with each deposited track and gradually attains its desired shape.

In current material extrusion printers (including granulate extruders, ram extruders and syringe extruders), the material is deposited in a feed forward, flow-controlled way. The flow of the modeling material is kept constant, depending on thickness of the tracks to be deposited and the print speed. As part of the machine calibration, the material flow is calibrated.

Moreover, the X-Y-Z positioning system which causes the printhead to move over the previously deposited tracks of the object being created must be calibrated in order to maintain accurate dimensions of the object to be created and especially to maintain a controlled thickness of the tracks being deposited.

When the calibration is correct, solid objects can be printed accurately using flow control. When the gap between the printhead nozzle and the previously deposited layer for example increases due to lack of calibration, the flow of modeling material can become too small to fill up the gap, thereby causing the occurrence of spaces between the printed tracks, resulting in cavities in the printed object. This is called under-extrusion.

On the other hand, when the gap between the printhead nozzle and the previously deposited layers decreases due to lack of calibration, the flow of modeling material can become too high for the track being deposited, so too much material will be extruded. This is called over-extrusion. Over-extrusion can also occur when the track is laid between two previously deposited tracks and the space there between is narrowing. This may result in excessive forces between the object and the printhead and in a rough surface of the object due to overflow of the modeling material. The overflow of modeling material may lead to debris or residue on the nozzle tip of the printhead which may come off the nozzle tip and fuse with the object being printed and cause potential loss of the object. Also, the print head smears over the object being printed, causing a very rough top surface of the object and excessive forces which ultimately cause the object from breaking loose from the build plate.

Loss of calibration may also be caused by thermal expansion while printing and subsequent shrinking after printing of thermally fused material. When the thermal expansion and shrinking are insufficiently compensated, the gap between nozzle and previously deposited layers may not have constant dimensions. Likewise, also dimensions in directions perpendicular to the deposition direction by the printhead or nozzle may vary due to thermal effects.

Another cause of under- or over extrusion may lie in variation of the modeling material feedstock dimensions. When for example filament of modeling material is used, its diameter may vary causing variations in the amount of modeling material deposited when printing, giving cause to under-or over-extrusion when using constant flow control of the modeling material being deposited.

When performing the calibration of the X-Y-Z system and of the feeding means of the modeling material, the highest priority is to prevent over-extrusion, since this will make the process unreliable. Therefore additive manufacturing (like fused deposition modeling) extrusion printers usually have some degree of under-extrusion causing formation of open spaces or cavities. As a side effect, parts will not be leak-tight or pressure resistant and the strength of the part will be sub-optimal.

Generally, the mechanical properties of an object prepared by fused deposition modelling (FDM) of a modeling material (like for example a thermoplastic polymer composition) are less favorable than an object with the same dimensions made by injection molding. In injection molding of a thermoplastic polymer composition, all polymer chains have strong interactions due to the fluid state of the polymer and will have ample time to entangle and solidify to form a strong object. The mechanical properties of the object are mainly determined by the polymer composition used to prepare the object. In FDM, a new layer in a fluid state is provided onto an existing layer which has already solidified. The polymer chains of the new layer have a limited possibility to entangle with the solidified material of the existing layer, and also bonding with the existing layer will be limited. Accordingly, the adhesion between the new layer and the existing layer is weaker than the adhesion between the polymer chains within the same layer. This results in an object having lower mechanical properties in the Z-direction than in the X-direction and Y-direction.

US2014/0141166 describes an FDM process using a blend of 2 polyamides: the blend comprises at least one semi-crystalline polyamide and one amorphous polyamide. The blends are being printed in order to generate a dimensionally stable part. The parts are conditioned with water after being printed. The conditioning reduces the porosity of the parts, since the polyamides will absorb water through the conditioning step and swell. the reduction of the porosity is attributed to the very specific blend of two polyamides. The US2014/0141166 mentions different comparative materials that do not show this effect, like for example polethermide, ABS, virgin PA12 polyamide and carbon filled PA12.

WO2015/193819 relates to a method and apparatus for increasing bonding in material extrusion additive manufacturing. It discloses the preamble of claims 1 and 12.

SUMMARY

It is therefore an object of the invention to overcome the above described problems and disadvantages.

According to one aspect, the invention provides a three-dimensional object created by Fused Deposition Modeling (FDM) according to claim 1.

Accordingly, fused deposition modeling according to the invention is performed such that under-extrusion is avoided so that the object has less volume of cavities, and a low porosity.

Preferably the porosity is less than 1 vol%, or less than 0.5 vol%, less than 0.2 vol%, or even less than 0.01 vol%.

Porosity is a measure for the presence of cavities inside an object. Another indication for the presence (or preferably absence) of cavities is a leaktest. In the leaktest, leakage of air is measured through a sample of an object.

When an object has no cavities, the object will be leak tight. Preferably, the object according to the invention has an air leak tightness below $10 \times 10^{-6}$ mbar·l/s, preferably below $4.3 \times 10^{-6}$ mbar·l/s, more preferably between 0 and $3 \times 10^{-6}$ mbar·l/s, as determined by a leak test procedure (see definition below).

Figure 13 shows the typical structure of a sample according to the invention (schematic).

Figure 14 shows a typical structure of 3D printed object according to the prior art (schematic).

Preferably, the three-dimensional object according to the invention has a high isotropic strength, which means that the mechanical properties (strain and ultimate strength) are similar in all directions (X, Y, Z). Usually in FDM, the mechanical properties in the Z direction are lower compared to the mechanical properties in the X and Y direction. Herein the X and Y direction are parallel to the build plate of the FDM apparatus, and the Z direction is perpendicular to the build plate of the FDM apparatus.

Accordingly, the FDM process according to the invention is preferably performed in such a way that when a test specimen having dimensions according to ISO 527-2:2012 specimen 5A is made from said modeling material by said FDM process, the ultimate tensile strength of the test piece in the Z-direction is at least 70% of the ultimate tensile strength of the test piece in the X-direction or Y-direction, wherein the ultimate tensile strength is measured according to ISO 527-2:2012 SPECIMEN 5A.

Preferably the ultimate strength in the Z direction is at least 80%, more preferably 85% or 90 % compared to the X or Y direction of the testpiece.

The thermoplastic polymer composition may contain any thermoplastic polymer which can be used for FDM. Preferred example of modeling materials are selected from the group of polyaryletherketones (PAEK), polyphenylsulfides, polyamide-imide, polyethersulfon, polyetherimide, polysulfon, polyphenylsulfon, polycarbonates (PC), poly(acrylonitrile butadiene styrene) (ABS), polymethylmethacrylate (PMMA), polyethyleneterephtalate (PET), polystryrene (PS), acrylonitrilstyrene acrylate, polypropylene (PP), polylactic acid (PLA), polyvinyl alcohol (PVA), polyethylene (PE), polyoxymethylene, polyurethane (PU), copolymers of polyvinylalcohol and butenediolvinylalcohol and mixtures therefore, optionally filled with inorganic or organic fillers. Preferred examples of the thermoplastic polymer are polyethylene, polypropylene, ABS, polycarbonate, and polyarylether ketones (PAEK) like for example polyether ketone (PEK), polyether ether ketone (PEEK), polyether ketone ketone (PEKK), polyether ether ketone ketone (PEEKK) and polyether ether ketone ether ketone ketone (PEKEKK) and combinations thereof. Most preferably the polymer is PEEK. The polymer composition may further comprise additives and fillers as customary in the art.

In a preferred embodiment the thermoplastic polymer composition comprises at least 80 wt% of a PAEK, preferably at least 90 wt% of a PAEK. In a particularly preferred embodiment the thermoplastic polymer composition comprises at least 80 wt% of PEEK, preferably at least 90 wt% of a PEEK, more preferably PEEK.

Preferably, the thermoplastic polymer composition comprises at least 80 wt% of a PAEK, preferably PEEK, and a test piece having dimensions according to ISO 527-2:2012 SPECIMEN 5A made from said polymer composition by said additive manufacturing has an ultimate tensile stress according to ISO 527-2:2012 SPECIMEN 5A in any of the X, Y, Z directions (as defined above) of at least 50, preferably at least 60, or 70, or 80 MPa.

Printing of PEEK is extremely difficult, due to the high printing temperature, which is very close to the decomposition temperature, and the high thermal expansion/shrinkage of PEEK. FDM printing a part from PEEK giving an object having high mechanical properties has not yet been reported in literature.

The invention also relates to an object created by FDM from a thermoplastic composition comprising at least 80 wt% of a polyarylether keton (PAEK), according to claim 12.

The object is preferably obtained in a process wherein the FDM is performed by providing a layer in an X-Y plane having X-direction and Y-direction and successively adding further layers on top of said layer in Z-direction by depositing a modeling material onto predetermined positions, wherein X-direction, Y-direction and Z-direction are perpendicular to each other, wherein the depositing step involves

a. exerting a pressure on the modeling material to feed the modeling material onto the predetermined positions;
b. determining a parameter indicative for the pressure exerted on the modeling material and
c. controlling the feeding depending on said parameter. and wherein providing of each of the layers is performed by
d. printing contour lines of the object in the X-Y plane marking a primary area,
e. filling a first part of the primary area inside the contour lines of the object in the X, Y plane, leaving open a second part in the primary area,
f. filling the second part by the depositing step.

Testing procedures

**Porosity test procedure**

*Optical setup*

The optical setup consists of:

- A Basler acA1920-50 gm digital monochrome camera with a 11.3 mm × 7.1 mm sensor with 1920 × 1200 pixels
- An Edmund Optics 1X, 40mm WD CompactTL™ telecentric lens 1x magnification and through the lens illuminator port
- A Dolan-Jenner MI-150 Fiber Optic Illuminator with a 150 W lamp with 3250K color temperature configured to provide on-axis illumination
- A Thorlabs GN2/M dual axis manual gonio stage with sample holder.

*Sample preparation*

The sample shall contain an area of at least 15 mm × 10 mm printed with 100% infill The sample is potted in a puck to maintain flatness of the surface during polishing. The following potting material is used: 7 parts Streuers Specifix-20, with 1 part Streuers Curing agent and the samples is impregnated under vacuum.

The plane of the cross section is perpendicular to the printing direction.

Both sides of the puck are grinded to make the planes parallel and to make a cross section showing only the infilled area.

The grinding and polishing procedure with the Struers polisher and Struers consumables is:

- 80 grid: 150 seconds at 150 rpm and 20 N force
- 800 grid: 120 seconds at 150 rpm and 20 N force
- 1200 grid: 120 seconds at 150 rpm and 20 N force

- 2000 grid: 120 seconds at 150 rpm and 20 N force
- 4000 grid: 120 seconds at 150 rpm and 20 N force
- 3 $\mu$m diamond paste: 180 seconds at 150 rpm and 25 N
- 5 minutes ultrasonic cleaning
- 1 $\mu$m diamond paste: 180 seconds at 150 rpm and 30 N
- 10 minutes ultrasonic cleaning
- Careful removal of remnants of the polishing step to obtain a clean surface.

While grinding the grinding disc and sample area are flooded with cold flowing water in order to prevent sample heating to damage the surface texture.

The samples are grinded until the surface is smooth and hardly any polishing scratches are visible under the microscope.

Subsequently use polishing paste to remove remaining scratches.

This polishing procedure is standard operation for a person skilled in the art.

*Imaging*

Adjust both rotations of the manual rotating stage while observing the camera image such that the polished surface is exactly perpendicular to the optical axis of the optical system and the illumination light is exactly reflected into the camera, obtaining the highest brightness and contrast.

Adjust the shutter time of the camera such that:

- less than 1% of the pixels are underexposed, i.e have an intensity of less than 1% of the dynamic range and
- less than 1% of the pixels are overexposed, i.e. have an intensity of more than 99% of the dynamic range

Images must be stored with full resolution and single channel grey image without image compression.

A solid piece of printed material should be visible inside the field of view, without the skin or the edge of the part being visible in the image.

Ensure at least 10 and no more than 25 tracks are imaged to the width of the image sensor.

Ensure at least 14 and no more than 40 layers are imaged to the height of the image sensor.

If the structure of the printed tracks is too large or too small to allow for this number of printed tracks or layers in the field of view, use a lens with similar optical properties but different magnification and scale the size of the sample accordingly.

*Image post processing*

The following post procedure assumes that the cavities are dark colored and the print material in between is bright. The images are imported and processed as signed 16 bit integers.

1. Determine a variable R measured in pixels which is 1/1 0th of the long short side of the image.
2. Create a copy of the image and apply a median filter to the copy of the original image with a square shaped structural element with width and height 2*R (or the nearest odd integer value if this is required by the implementation of the algorithm)
3. Subtract the filtered image from the image from step 2 and add a value of 15 20 to each pixel in the same step
4. Check if the resulting image is not clipped according to the 1% criterion mentioned above. In case clipping occurs, adjust the illumination and shutter time and repeat the procedure
5. Convert the resulting image to a binary image, converting each pixel with positive value to 1, and all other pixels to 0
6. Perform region erosion with a disk shaped structural element with a radius of 31.5 pixels
7. Perform region dilation with a disk shaped structural element with a radius of 5.53.0 pixels
8. Perform region erosion with a disk shaped structural element with a radius of 31.5 pixels
9. Crop the resulting image, cropping off a band of width R from each edgeleaving a square portion as large as the height of the original image
10. Determine the number of black pixels with a pixel value of 0
11. Determine the total number of pixels
12. Calculate the porosity as the quotient of the number of black pixels and the total number of pixels, expressed in percent.

The source code for calculating the porosity is a Python source code and is defined as:

Version of Python used: 3.6.4 (v3.6.4:d48eceb, Dec 19 2017, 06:54:40) [MSC v.1900 64 bit (AMD64)]
Version of NumPy used: 1.14.0
Version of openCV used: 3.4.0

```python
import numpy as np
import cv2
import os
import sys
def VisionAlgorithm(image, blurRadius=10, threshold=20, erodeRadius=1.5,
dilateRadius=3.0):

    # 1) Determine blur radius
    height, width, depth = image.shape

                        R = round( height / blurRadius )

    # 2) Perform median blur

                        blurred = cv2.medianBlur(image, R*2+1)

    # 3) Convert to signed int to prevent overflow when subtracting

        img16 = np.int16( image[:,:,1])
        blurred16 = np.int16( blurred[:,:,1])

    # 4) Subtract images and add threshold

                        difference = img16 - blurred16 + threshold

    # 5) Convert to binary

        binary = difference < 0
        binary = np.uint8(binary)

    # 6) Erode

            X,Y = [np.arange(-2*(erodeRadius+1),2*(erodeRadius+1)+1)]*2

            disk1 = np.uint8(X[:,None]**2 + Y**2 <= erodeRadius*erodeRadius)

                        erosion = cv2.erode(binary,disk1,iterations = 1)

    # 7) Dilate

            X,Y = [np.arange(-2*(dilateRadius+1),2*(dilateRadius+1)+1)]*2

            disk2 = np.uint8(X[:,None]**2 + Y**2 <= dilateRadius*dilateRadius)

                        dilation = cv2.dilate(erosion,disk2,iterations = 1)
```

```
# 8) Erode again

erosion2 = cv2.erode(dilation,disk1,iterations = 1)

# 9) Only use center square portion of the image

leftMargin = int((width - height)/2)

cropped = erosion2[0:height, leftMargin:leftMargin+height]

# 10) Count black pixels

blackPixels = (cropped == 0)
black = np.sum(blackPixels == 0)
H, V = blackPixels.shape

porosity = 100*black/(H*V)

# 11) Create blended image to display the result

center = image[0:height, leftMargin:leftMargin+height]

islands=np.zeros( (H,V,3), np.uint8)
islands[:,:,2]=255*(cropped > 0)
blend = cv2.addWeighted(center,0.7,islands,0.2,0)
header='porosity'

result='{porosity}%'.format(porosity=porosity)

# Return the header, the results and the image back to the main program return (header, result, blend)

# MAIN PROGRAM
# Determine a list of files to be processed
results=[]
# Prepare a directory for storing result files

resultsDir=os.path.join(os.getcwd(), 'results')
if not os.path.isdir(resultsDir):
os.mkdir(resultsDir)

for de in os.scandir(os.path.join(os.getcwd(),'samples')):
if de.name.lower().endswith('png'):

    # Derive the file name

    sample, extension = os.path.splitext(de.name)
    path = de.path

    # Open the image file
    image = cv2.imread(path, cv2.IMREAD_UNCHANGED)
    # Have the image processed by the vision algorithm
```

```
        header, result, blend = VisionAlgorithm(image)
        header='sample\t'+header
        result=sample+'\t'+result

        # Store the blend of the image and the voids as a result image

        sampleFile='%s.png' % sample
        resultfile=os.path.join(resultsDir, sampleFile)
        cv2. imwrite(resultfile, blend)

        # Append the header to the results list if required
        if len(results)==0:

            print(header)
            results.append (header)

        # Append the results to the result list

            print(result)
            results.append(result)

    results.append('')
    results.append('Version of Python used: %s' % sys.version)
    results.append('Version of NumPy used: %s' % np.version.version) results.append('Version of openCV used: %s'
    % cv2._version_)
    # Write the results to file
    resultfile=os.path.join(resultsDir, 'results.txt')
    open(resultfile, 'w').writelines(['%s\n' % s for s in results])
```

**Leak test**

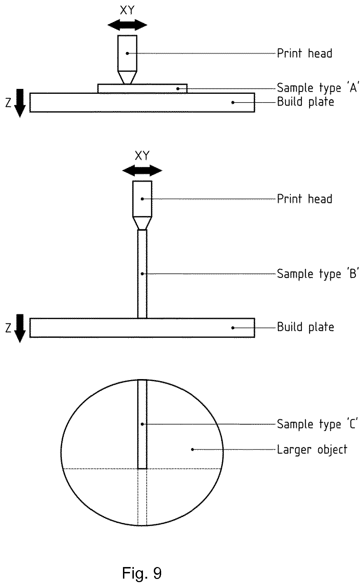

For testing the leak tightness, test specimens A, B and C are defined, each with a cuboid shape of 20 mm $\times$ 20 mm $\times$ 2 mm (see figure 9):

- test specimen type 'A' is printed in the XY plane of the printer
- test specimen type 'B' is printed perpendicular to the XY plane of the printer
- test specimen type 'C' is retrieved by sawing the specimen from a larger printed object

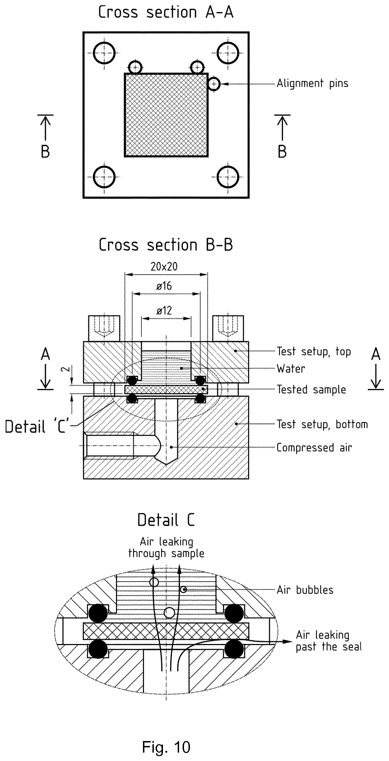

The test is performed with the test setup according to figure 10. The test sample is placed horizontally in the test setup. Above the test sample is water. Under the test sample is compressed air with an air overpressure of 6 bar. Leaking of air or water past the sample is prevented by O-rings with an inner diameter of 14 mm and an outer diameter of 19 mm. The construction of the setup is such that if the O-ring seal is imperfect, air will flow to the environment and will not lead to false detection of a leak through the sample.

While the sample is exposed to the test overpressure of 6 bar, the occurrence of air bubbles in the water is observed. If over a period of 10 minutes no air bubbles larger than ø1 mm are observed, the sample is considered leak tight. The leak tightness is preferably below $10\times10^{-6}$ mbar·l/s, more preferably below $4.3\times10^{-6}$ mbar·l/s, most preferably between 0 and $3\times10^{-6}$ mbar·l/s. The leak tightness value in mbar·l/s number can be calculated by estimating the total volume of the (assumingly spherical) air bubbles, multiplying this by the overpressure (6 bar) and dividing this by the test period (10 minutes). The diameter of the air bubbles can be measured with a suitable, calibrated digital camera

Of each sample, 3 random samples are tested according to the test method as described below. Thus a total of 9 experiments are carried out. The samples are considered leak tight if all 9 samples pass the test.

Test specimen for mechanical testing.

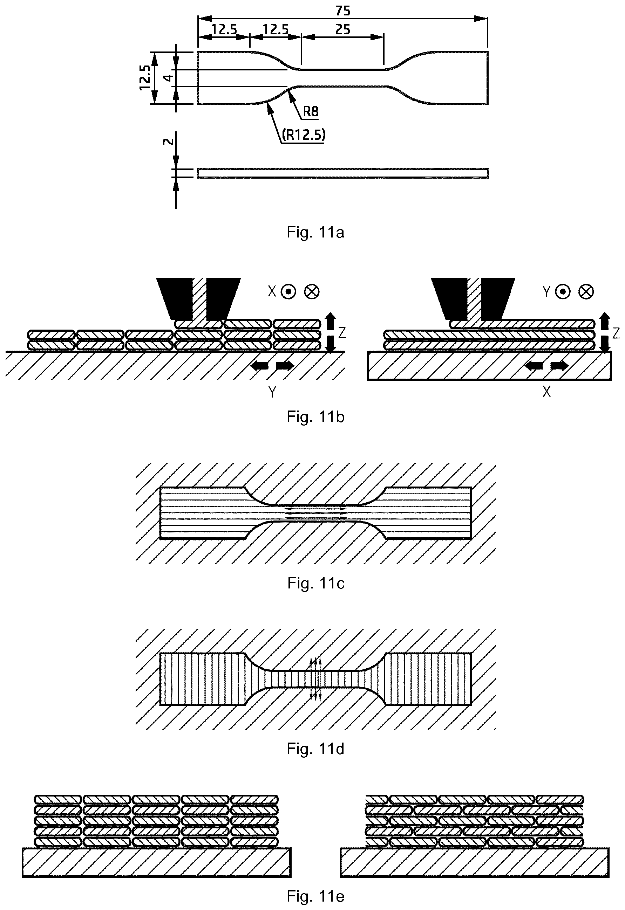

For the determination of the mechanical properties of the printed parts, test specimens 'D', 'E' and 'F' are defined. Each test specimen has dimensions according to ISO 527-2:2012 specimen 5A (see also figure 11a).

A coordinate system is defined which is oriented relative to the direction of printing (see figure 11b).

Test specimen type 'D' is printed flat on the print bed, with print tracks in the direction of the tensile bar, such that the tensile strength in X-direction can be measured (figure 11c).

Test specimen type 'E' is printed flat on the print bed, with print tracks in the direction of the tensile bar, such that the tensile strength in Y-direction can be measured (figure 11d).

For test specimens 'D' and 'E', the printed tracks are printed on top of each other (see figure 11e left). A 'bricklaying structure' is not allowed (figure 11e (right)).

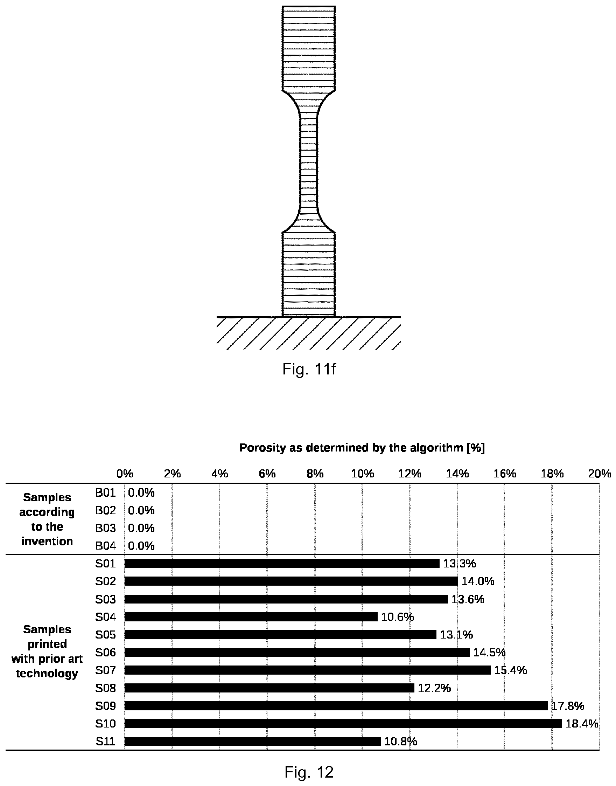

Test specimen type 'F' is printed upright with respect to the print bed, such that the tensile strength in X-direction can be measured (figure 11f).

The specimens are printed with a solid infill. If desired to obtain optimal mechanical properties, thermal treatment is applied. Specimens are printed with small overdimensions and milled down to obtain the correct dimensions and fine surface roughness.

Of each specimen, three samples are printed. The mean value of the mechanical properties is taken.

The process according to the invention can be performed with different modeling materials. The most common modeling material to be used is a thermoplastic polymer. Is it also possible to use other modeling materials, like for example reactive liquids, resins, filled materials like for example concrete, gypsum, thermosetting materials, elastomers, liquid crystal polymers, 2K polymers, polymer clay or binded ceramics.

The objects according to the invention can be obtained by fused deposition modelling (FDM) in which the depositing of a modeling material (like for example a thermoplastic polymer composition) onto the predetermined positions is controlled according to the pressure exerted on the modeling material. More in particular, depositing of the modeling material onto the predetermined positions involves

- exerting a pressure on the modeling material to feed the modeling material onto the predetermined positions;
- determining a parameter indicative for the pressure exerted on the modeling material and
- controlling the feeding depending on said parameter.

In some embodiments, providing of each of the layers is performed by

- printing contour lines of the object in the X-Y plane marking a primary area,
- filling a first part of the primary area inside the contour lines of the object in the X, Y plane, leaving open a second part in the primary area
- filling the second part by the depositing step.

In some embodiments, filling of the first part is performed by feeding the modeling material (like for example the thermoplastic polymer composition) onto the predetermined positions in a flow-controlled way.

An example of an additive manufacturing system for creating the three-dimensional objects according to the invention comprises an additive manufacturing printhead, wherein the printhead is attached to positioning means spatially moving at least one of the printhead and the object being printed relative to one another.

The printhead comprises a tubular feed member and a nozzle arranged at one end of the tubular feed member, the nozzle having an outlet for dispensing modeling material, and a nozzle tip, for facing previously deposited tracks of modeling material on the object to be created. The modeling material can be a thermoplastic polymer composition.

The tubular feed member comprises a feed channel for feeding the modeling material to the nozzle outlet.

The system further comprises modeling material feeding means arranged at an end of the tubular feed member opposite of the nozzle, wherein the modeling material feeding means are arranged for exerting a pressure exerted on the modeling material within the feed channel towards the nozzle.

The system further comprises pressure determining means for determining a parameter indicative for a pressure exerted on the modeling material.

The system further comprises a control system arranged for controlling the modeling material feeding means based on the determined parameter indicative for a pressure exerted on the modeling material.

By controlling the pressure, it can be sensed by the control system using the pressure determining means that the under-extrusion occurs when for example the pressure drops below a certain level. By increasing the pressure exerted on the modeling material within the tubular feed member, this under-extrusion can be compensated for. This may occur for example when a space between previously deposited adjacent tracks is widening while depositing the current track.

On the other hand, it can be sensed that over-extrusion occurs when the parameter indicative of the pressure exerted on the modeling material pressure increases above a certain level. By decreasing the pressure exerted on the modeling material within the tubular feed member, this over-extrusion can be compensated for. This may occur for example when a space between previously deposited adjacent tracks is narrowing. By controlling the pressure of the modeling material, remaining spaces in the printed object will be filled well, independent of the volume of the remaining space. This will result in fusing of the track being deposited with the previously deposited adjacent tracks, causing total infill of cavities and improved bonding between adjacent tracks. Therefore, parts will have optimal leak tightness and strength.

The track thickness, determined by the gap between nozzle and previously deposited layer, is usually very small. This implies that the pressure drop over this gap is large due to viscosity of the modeling material. It requires only a distance in the order of magnitude of a millimeter for the pressure drop from the level of the pressure in or at the nozzle tip to reach ambient pressure. As the distance to the nozzle becomes larger, the pressure drop over the gap increases. When the pressure drop is equal to the overpressure in the nozzle, the flow stops and the track does not become wider. As the printhead moves over the object, this balances out to become a stable track width The main difference with flow controlled printing is that width of the track being deposited balances out to a constant line width while filling up all the gaps nicely, while flow based printing would soon result in systematic under- or over-extrusion.

By controlling the pressure exerted on the modeling material, variations in the gap size between the nozzle and previously deposited tracks are compensated for.

In an embodiment, the control system is arranged for controlling the modeling material feeding means to maintain a pressure exerted on the modeling material between a predetermined minimum pressure value and a predetermined maximum pressure value. This allows the pressure exerted on the modeling material to be within a range ensuring that no over- or under-extrusion occurs, regardless of imperfections of alignment or calibration of the positioning means.

In an embodiment, the control system is arranged for maintaining the parameter indicative for a pressure exerted on the modeling material at a constant value. This further improves tracks to be deposited between or adjacent previously deposited tracks to be filled up fully without leaving open spaces, or cavities, while preventing formation of debris and residue. Moreover, the constant pressure reduces wear in the printhead and modeling material feeding means.

In an embodiment, the modeling material feeding means comprise a controllable drive and transmission means connected to the drive for transferring a force generated by the drive to the modeling material. The controllable drive allows the control system to generate a controllable force which results in a pressure exerted on the modeling material within the tubular feed means, i.e. the feed channel and a pressure exerted on the modeling material at the nozzle tip.

In an embodiment, the pressure determining means for determining a parameter indicative for a pressure exerted on the modeling material comprise pressure determining means for determining the parameter indicative of the pressure exerted on the modeling material within the feed channel. This allows for example the parameter indicative for a pressure exerted on the modeling material to be determined by the force exerted on the modeling material by the controllable drive and the transmission means. The thus determined parameter constitutes a measure indicative for the pressure exerted on the modeling material within the feed channel.

Depending on the modeling material, an appropriate drive and force transmission means can be chosen. The controllable drive is controllable by the control system. Forces at the nozzle tip and torque within the drive and transmission system can be considered indicative for a pressure exerted on the modeling material.

In an embodiment, the controllable drive comprises a rotary drive, and the pressure determining means for determining the parameter indicative of the pressure exerted on the modeling material on the modeling material within the feed channel comprise torque determining means for determining a torque exerted by the rotary drive and/or transmission. This allows the parameter indicative of the pressure exerted on the modeling material to be derived from the torque exerted by at least one of the rotary drive and the transmission.

In an embodiment, the controllable drive comprises an electric motor, and wherein the torque determination means comprise a motor current measuring means. This allows torque determination without any further torque sensor.

In an embodiment, the modeling material feeding means comprises a plunger for feeding modeling material into the modeling material feeder. The plunger allows modeling material in the form of rods to be fed into the tubular feed member.

The parameter indicative for a pressure exerted on the modeling material within the feed channel is determined by the pressure exerted on the modeling material by the plunger, and wherein the pressure determining means for determining the parameter indicative of the pressure exerted on the modeling material within the feed channel comprise a force sensor, arranged at the plunger for measuring the pressure exerted by the plunger on the modeling material.

From the exerted force, the parameter indicative for the pressure exerted on the modeling material within the feed channel can be derived. This is an alternative way to measuring motor current or torque from the drive system to easily determine the parameter indicative for a pressure exerted on the modeling material within the feed channel of the tubular feed member.

In an embodiment, the pressure determining means for determining the parameter indicative of the pressure exerted on the modeling material within the feed channel comprise a pressure sensor connected to the feed channel of the tubular feed member. Thus the parameter indicative of the pressure exerted on the modeling material within the feed channel can be determined directly by the pressure sensor.

In an embodiment, the pressure determining means for determining the parameter indicative of the pressure exerted on the modeling material within the feed channel comprise a pressure sensor connected to the feed channel at the nozzle. Thus the parameter indicative of the pressure exerted on the modeling material within the feed channel can alternatively be directly determined by the pressure sensor within the nozzle.

In an embodiment, the pressure sensor arranged at the nozzle comprises a nozzle deformation sensor. This has an advantage that the sensor does not need direct contact with the flow of modeling material within the feed channel of the nozzle.

In an embodiment, the pressure determining means for determining a parameter indicative of a pressure exerted on the modeling material comprise pressure determining means for determining a parameter indicative of a pressure exerted on the modeling material within the track being deposited. This allows direct measurement and control of the modeling material within the track being deposited, thus ensuring smooth deposition of the modeling material and optimal fusing with laterally previously deposited tracks.

In an embodiment, the pressure determining means for determining a parameter indicative of a pressure exerted on the modeling material within the track being deposited comprise a pressure sensor having a fluid channel at the nozzle tip for measuring a pressure in the deposited modeling material at the nozzle tip. The fluid channel at the nozzle tip allows measuring a pressure in the deposited track outside the nozzle near the nozzle outlet. This allows direct measurement of the pressure at the nozzle tip, within the modeling material being deposited, ensuring fast and accurate pressure measurement.

In an embodiment, the pressure determining means for determining the parameter indicative of a pressure exerted on the modeling material within the track being deposited comprise a force sensor arranged between the printhead and the positioning means. The force exerted by the printhead, i.e. nozzle tip, on the modeling material of the track being deposited, can be measured by measuring a counterforce at a different location in the mechanical path from the printhead via the gantry and positioning system, base, to the object to be created, which transmits the force exerted by the printhead on the track being deposited. From the determined force, the pressure exerted on the modeling material at the tip can be derived.

In an embodiment, the force sensor is arranged at an interconnection of the printhead and the positioning means. In this case the force can be measured between the printhead and positioning means, more specifically the gantry against which the printhead is mounted.

In an embodiment, the pressure determining means for determining the parameter indicative of a pressure exerted on the modeling material within the track being deposited comprises a force sensor arranged on a base of the positioning means, which is arranged for receiving the object to be created. The object to be created is located at the reference location. It can be mounted on the base. A force on the build plate can be measured, or alternatively a force between the build plate and positioning means can be measured from which the parameter indicative of the pressure can be derived.

The determined pressure can be compensated by the weight of the object being printed. This weight can for example be determined by the force sensor when the printhead is not active or withdrawn. This can be performed in time intervals during the printing process wherein the deposition of tracks is performed.

In an embodiment, the system further comprises modeling material flow determining means. This allows determination of an amount of modeling material used in depositing tracks. From the modeling material flow and printing speed a thickness of the deposited tracks can be determined.

In an embodiment the flow determining means comprise a displacement sensor for determining displacement of the modeling material feeding means, and wherein the control system is arranged for determining the flow by determining a displacement per unit in time. The modeling material feeding means push the modeling material into the tubular feed member. By measuring a displacement of the feeding means per time unit, a modeling material flow can be determined from the displacement in time and a cross section area of the tubular feeding member.

In an embodiment, the control system is arranged for alternatively controlling a flow of the modeling material using the determined modeling material flow, and controlling the pressure exerted on the modeling material.

In an alternative embodiment, the flow determining means comprise a flow sensor for determining flow of the modeling material feeding means.

In an embodiment, the flow determining means comprise a sensor for determining a rotation speed of the rotary drive. The rotary drive drives the modeling material feeding means. Displacement of the modeling material within the tubular feed member is thereby linked to the rotary speed of the rotary drive. Thus from the rotary speed of the rotary drive the modeling material flow in the tubular feeding member can be derived. This has an advantage in that when an electric motor is utilized as rotary drive, the rotary speed can easily be determined from electric parameters associated with the driving of the motor. Thus no separate displacement sensor is required.

In an embodiment, the control system is arranged for controlling the positioning means and the printhead for depositing two first tracks using flow control, wherein the first two tracks are spaced apart, and wherein the control system is arranged for controlling the positioning means and the printhead for depositing an intermediate track between the two first tracks while controlling the pressure exerted on the modeling material. In this scheme, the first tracks are deposited independent of previously deposited tracks. Such tracks do not require a high filling grade for preventing spaces and cavities, thus flow control can be used. The intermediate second track to be deposited between the first two tracks however require the high filling grade leaving no cavities. Thus this third track can be deposited using pressure control.

In an embodiment, the tubular feed member is heatable by a heating element arranged around at least a lower portion of the tubular feed member adjacent to the nozzle. This allows heatable modeling material to be processed by the fused deposition modelling system. The modeling material is heated while it is pushed into the tubular feed member. When the modeling material reaches the nozzle, the modeling material is heated to its melting temperature. The heating element can be dimensioned and controlled to reach the required melting temperature.

In an embodiment, the nozzle is heatable by a heating element arranged around or within the nozzle. This allows the heating element of the tubular feed member to be adjusted to a lower temperature preventing the modeling material to thermally degrade as some materials can only be kept at a high temperature, i,e, melt temperature for a limited time. Only in the last part of the feed channel near the nozzle the modeling material is heated to its melting temperature, thus adequate printing is provided while the modeling material is maintained in good condition, i.e. degradation is prevented. An example of an additive manufacturing method for creating the three-dimensional object according to the invention comprises performing additive manufacturing using the system for additive manufacturing as described above.

The method further comprises:
depositing a first track of modeling material, comprising

- feeding the modeling material using the modeling material feeding means;
- determining a parameter indicative of a pressure exerted on the modeling material;
- controlling the modeling material feeding means depending on the parameter indicative of the pressure exerted on the modeling material.

In an embodiment, the controlling the modeling material feeding means depending on the parameter indicative of the pressure exerted on the modeling material comprises comparing the parameter indicative of the pressure exerted on the modeling material with a reference value, and wherein the controlling the modeling material feeding means is based on a difference between the exerted pressure and the reference value. In an embodiment, the controlling the modeling material feeding means depending on the pressure exerted on the modeling material comprises maintaining the parameter indicative of the pressure exerted on the modeling material between a previously determined minimum pressure value and a previously determined maximum pressure value.

In an embodiment, the controlling the modeling material feeding means depending on the parameter indicative of the pressure exerted on the modeling material comprises maintaining the parameter indicative of the pressure exerted on the modeling material at a previously determined constant value.

In an embodiment, wherein the step of depositing a first track of modeling material comprises depositing the first track in a space between a previously deposited second track of modeling material, and a previously deposited third track of modeling material, the third track being spaced apart from the second track.

In an embodiment the determining a parameter indicative of a pressure exerted on the modeling material comprises determining a parameter indicative of a pressure exerted on the modeling material within the feed channel of the tubular feed member and/or nozzle.

In an alternative embodiment, the determining a parameter indicative of a pressure exerted on the modeling material comprises determining a parameter indicative of a pressure exerted on the modeling material within the track being deposited.

BRIEF DESCRIPTION OF THE DRAWINGS

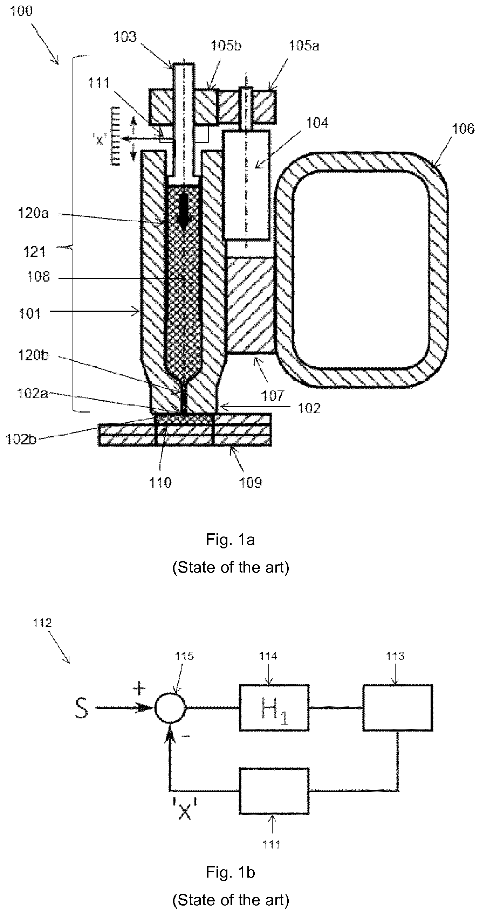

Fig. 1a shows a diagram of a system for additive manufacturing according to the state of the art.
Fig. 1b shows a block diagram of a control system for controlling a system for additive manufacturing according to the state of the art.

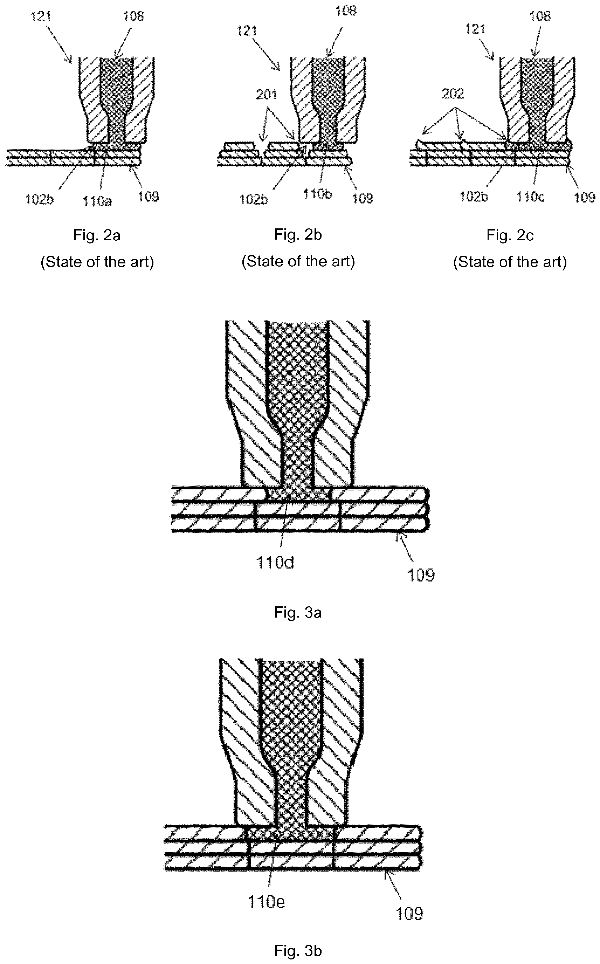

Figs. 2a - 2c show aspects of a system for additive manufacturing according to the state of the art.
Figs. 3a - 3b show aspects of a an additive manufacturing system for creating three-dimensional objects according to the invention.

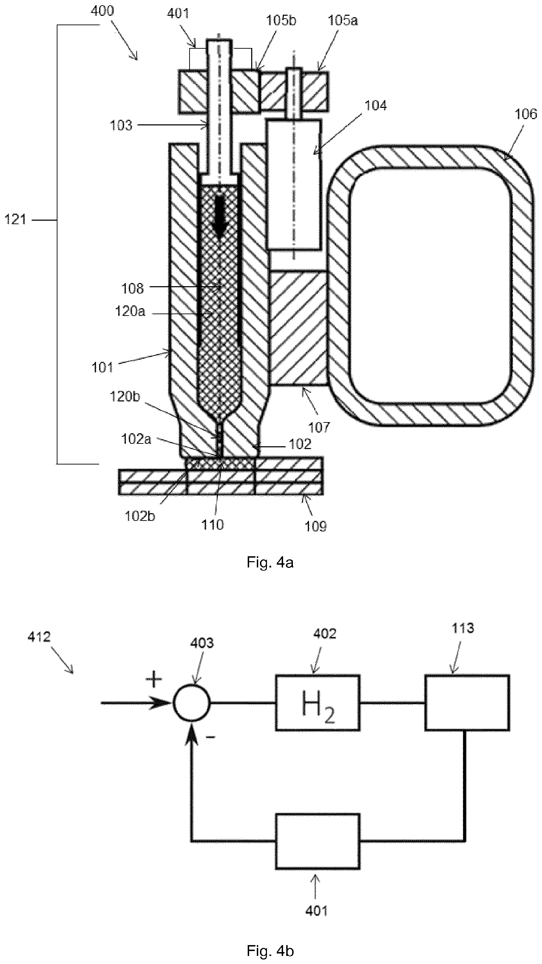

Fig. 4a shows a diagram of an additive manufacturing system for creating three-dimensional objects according to the invention.
Fig. 4b shows a block diagram of a control system for controlling an additive manufacturing system for creating three-dimensional objects according to the invention.

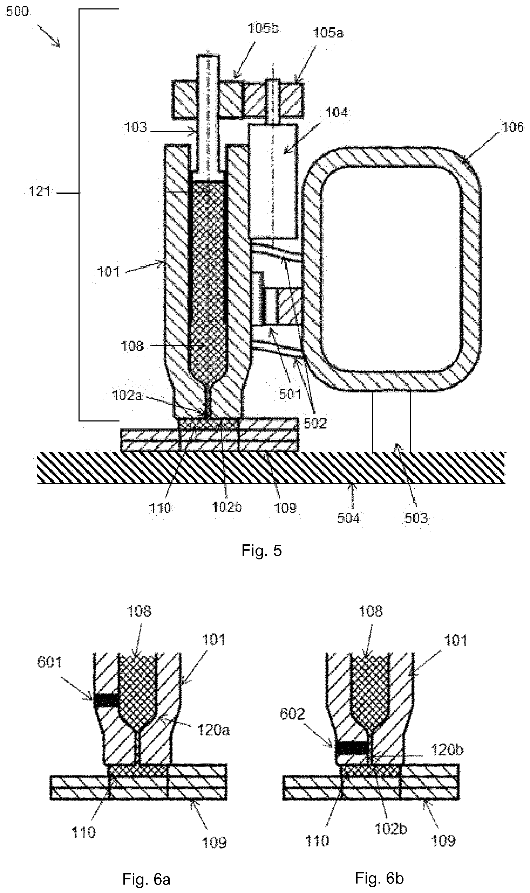

Fig. 5 shows a diagram of an additive manufacturing system for creating three-dimensional objects according to the invention.

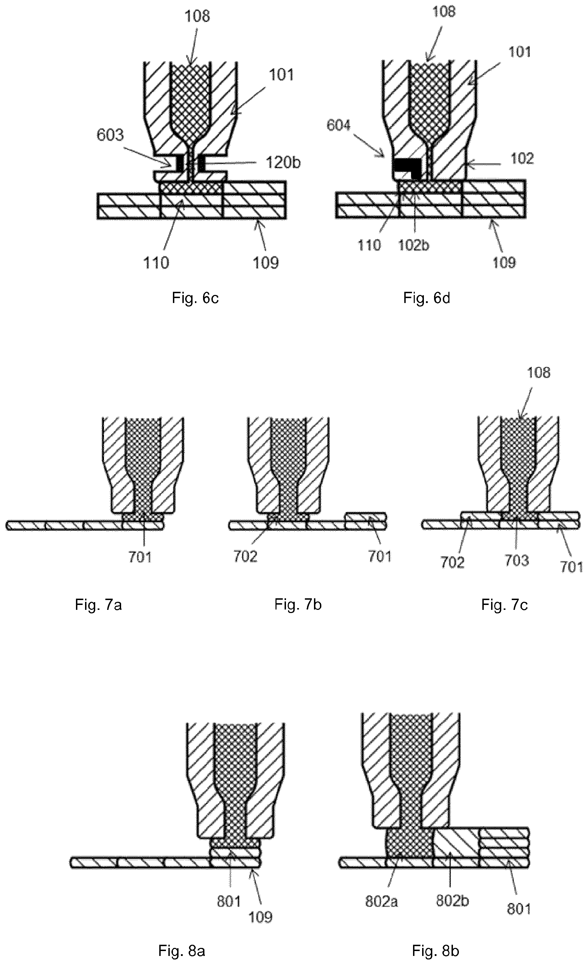

Figs. 6a - 6d show aspects of an additive manufacturing system for creating three-dimensional objects according to the invention.

Figs. 7a - 7c show aspects of an additive manufacturing system for creating three-dimensional objects according to the invention.

Figs. 8a - 8b show aspects of an additive manufacturing system for creating three-dimensional parts according to the invention.

Fig. 9 shows test specimens A, B and C for the leak test.

Fig. 10 shows the test set-up for the leak test.

Fig. 11a shows the ISO 527-2: 2012 specimen 5A.

Fig. 11b shows the coordinate system relative to the direction of printing.

Fig. 11c shows the orientation of test specimen D.

Fig. 11d shows the orientation of test specimen E.

Fig. 11e shows ordering of layers in the Z direction.

Fig. 11f shows the orientation of test specimen F.

Fig. 12 shows porosity test data.

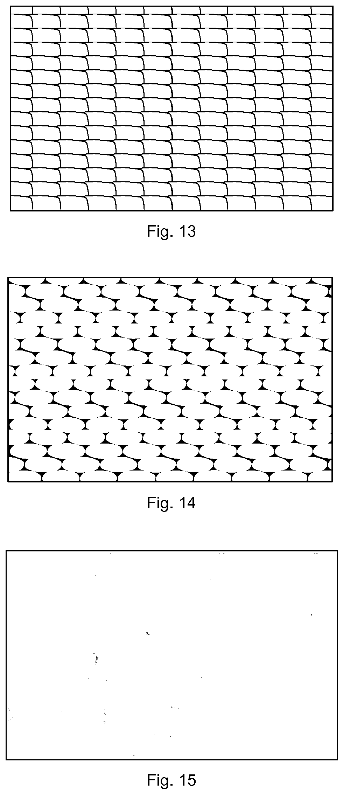

Fig. 13 shows a schematic image of a sample prepared according to the process of the present invention.

Fig. 14 shows an image of a sample produced in a prior art FDM process.

Fig. 15 shows a typical image of a sample according to the invention (at step 5 of the image processing procedure).

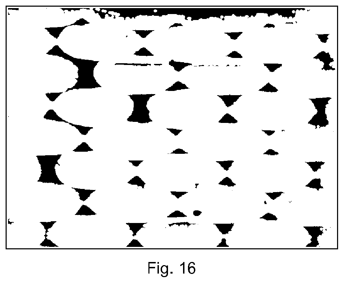

Fig. 16 shows a detail of an image of a sample according to the prior art (at step 5 of the image processing procedure).

## DETAILED DESCRIPTION OF EMBODIMENTS OF THE PROCESS

In fig. 1a a system for additive manufacturing 100 is shown in a simplified form. The system 100 comprises a view step position modeling printhead 121 attached via a connection 107 to a gantry 106, which gantry 106 is comprised in a X-Y-Z positioning system, not shown in fig. 1a, which allows the printhead 121 and object to be printed to be moved relatively to one another while depositing layers 110 of modeling material. The printhead 121 comprises a tubular feed member 101, which acts as an extruder tube, and which is arranged for feeding modeling material 108 from one end of the tubular feed member 101 towards a nozzle 102 connected at the opposite end of the tubular feed member 101. The tubular feed member 101 can for example be made from a metal, such as stainless steel.

The tubular feed member 101 and the nozzle 102 comprise a feed channel 120a, 120b respectively. The feed channel 120b of the nozzle 102 leads to the nozzle outlet 102a at the nozzle tip 102b. During printing, the nozzle tip 102b is in contact with the modeling material being deposited 110.

The modeling material 108 may include thermoplastic polymers such as for example polylactic acid (PLA), acrylonitrile butadiene styrene (ABS), polycarbonate (PC) and polyether ether ketone (PEEK). These materials can be melted within the tubular feed member 101 and dispensed from the printhead nozzle 102 in subsequent tracks 109, 110, for forming an object to be created.

The tubular feed member 101 and also the nozzle can be provided with one or more heating elements, which can be arranged around the tubular feed member 101, to heat and melt modeling material feedstock in order to allow the printhead to deposit and fuse modeling material in a molten state.

Other modeling materials can be deposited in thin tracks 109, 110 and optionally cured for example by exposure to ultraviolet light, air, heat, or other curing agents.

The modeling material 108 is deposited on a base in a first track, and on previously deposited tracks 109 in a successive deposition operations conducted by the X-Y-Z positioning system. The base can be a base plate, ground or any other structure suitable for initiating the deposition of tracks and building and carrying the object to be printed. The base can be fixed or movable. In some cases, the base is movable in a horizontal X_Y direction, whereas the printhead is movable in a vertical Z-direction. In other cases, the base is movable in X-Y-Z horizontal and vertical direction relative to the printhead. In again other cases, the printhead is movable in X-Y-Z horizontal and vertical direction relative to the base. In this description the latter case is provided by way of example.

While the printhead 121 is moved over the previously deposited tracks 109, a drive system comprising a drive 104, a transmission 105a,105b for transmitting the rotary motion of the drive 104 to a longitudinal motion of a plunger 103, which pushes the modeling material within the feed channel 120a of the tubular feed member 101 towards the nozzle 102. The rotation to translation transmission 105,a, 105b, 103 can be a spindle transmission, wherein the nut 105b is driven by the rotary drive 104. The pressure exerted on the modeling material 108 by the rotation to translation transmission can be derived from the determined torque using the transfer ratio of the angular displacement of the motor axle and the longitudinal displacement of the plunger 103 attached to a spindle of the rotation to translation transmission 105a, 105b, 103. The rotary drive 104 can be a stepper motor which can be controlled digitally to proceed a discreet number of steps in a chosen direction. The rotary drive 104 can also be an electric motor, DC or AC, or servomotor, which is controllable by voltage and/or current supplied to the motor. In the latter case, an encoder connected to the motor axle may provide position information of the motor.

The plunger 103 can be provided with a displacement sensor 111, which can be arranged to measure a displacement X of the plunger 103 relative to the tubular feed member 101. The state of the art as depicted in fig. 1a is shown as an example for example feeding modeling material rods in the tubular feed member 101 to the nozzle 102. In the art alternative examples of feeding modeling material to the nozzle are available, such as feeding modeling material filament into a tubular feed member 101 using for example filament punch rollers, which can be driven by an electric motor. The deposition of tracks 110 on top of previously deposited tracks 109 performed in similar ways using a X-Y-Z positioning system whilst the modeling material filament is fed into the tubular feed member 101.

The system 100 according to fig. 1a, can be controlled by a control system which is arranged to dispense additive manufacturing material at a rate proportional to a required track thickness and printing speed. In order to achieve this, a predetermined flow of the modeling material 108 is to be achieved. The control system controls the drive 104, and a displacement sensor 111 measures displacement X of the plunger 103. The displacement of the plunger 103 per time unit provides the flow of the modeling material 108, thereby allowing the control system to regulate the required amount of dispensed modeling material 108 in track 110.

In fig. 1b an example of a control system is shown wherein a set value S for the required flow is provided to a subtraction unit 115, which is arranged to subtract the calculated displacement X per time unit, thereby giving an error signal which can be supplied to a regulator module 114 of the control system.

The regulator module 114 can be provided with an appropriate transfer function H1, having a proportional, proportional and integrating, or proportional integrating and differential control function. The control system controls the drive 104 and transmission unit 105,105a and the transmission of the spindle transmission from the gear 105b to the plunger 103. The drive 104, transmission 105a, 105b and associated transmission ratio of these elements are symbolically depicted in block 113 of the example in fig. 1b. As descripted the displacement of the plunger 103 can be obtained from a displacement sensor 111, however the skilled person may find alternatives for establishing the displacement of the plunger 103.

In fig 2a. additive manufacturing 100 is illustrated according to the state of the art. A new track 110a of modeling material 108 is deposited on previously deposited tracks 109. In an ideal situation, the deposited tracks are continuously deposited. There are no gaps between the previously deposited tracks and tracks, neither in horizontal direction nor in vertical direction. This can be achieved when the flow of modeling material is accurately controlled relative to the required track thickness and deposition speed of the printhead 121. The degree and tightness of depositing modeling material 108 depends highly on calibration of the system or printer.

In fig. 2b, a common fault in flow controlled additive manufacturing is shown called under-extrusion. In under-extrusion, cavities or gaps 201 occur during the deposition of the modeling material. A track 110b is shown which is incompletely dispensed while printing on the printing on the previously deposed tracks. Such gaps 201 may occur when the additive manufacturing system is not properly calibrated. When performing the calibration, the aim is normally to prevent over-extrusion, since this will make the process unreliable. However, perfect calibration is not possible due to random errors, therefore additive manufacturing systems or printers usually have some degree of under extrusion. As a side effect, parts will not be leak-tight or pressure resistant and the strength of the part will be sub-optimal.

In fig. 2c, over-extrusion is represented. In over-extrusion, the flow of modeling material 108 into the deposited layer 110c is too high. As a consequence crests 202 of modeling material 108 may occur, caused by the nozzle tip 102b accumulating modeling material 108 and pushing excess modeling material to the sides, transverse to the deposition or printing direction.

In fig. 3a, track 110d of modeling material is deposited tight fitting between previously deposited tracks 109 independent of the volume of the remaining space between these tracks. Similarly in fig 3a. the space between the previously deposited tracks 109 is narrower than the tracks themselves.

In fig. 3b, the deposited track 110e is broader than the previously deposited tracks. This will result in total infill of cavities and improved bonding to adjacent and lower print tracks. Therefore parts printed in this way will have optimal leak tightness and strength, which can be achieved in a deposition modeling system as described below.

In fig. 4a a fused deposited modeling system 400 is shown similar to fig. 1a. A torque sensor 401 can be provided to measure the torque exerted by the drive 104 and transmission 105a, 105b to the plunger 103 and thereby to the modeling material 108. From the measured torque, a pressure exerted on the modeling material 108 in the tubular feed member 101 can be derived.

Alternatively, a pressure sensor may be attached to the plunger 103. The pressure sensor is arranged for measuring the pressure exerted by the plunger 103 to the modeling material 108. The plunger pressure sensor can be attached to the tip of the plunger 103 to measure the pressure exerted on the modeling material directly. The plunger pressure sensor can also be a force sensor attached to the point of engagement of the plunger 103 with the drive 104 and/or transmission system 105a, 105b. Moreover the pressure sensor can be a strain gauge attached the plunger stem.

When a pressure or force is applied to the plunger 103, this pressure or force is transferred to the modeling material 108. Due to the applied pressure or force, the plunger stem will deform, which can be measured by the strain gauge. The pressure exerted by the plunger 103 on the modeling material 108 in a higher end of the tubular feed member 101 eventually results in a pressure of the modeling material within the nozzle 102.

In fig 4b, a control system is shown for performing pressure controlled additive manufacturing with the system 400. As an example, the torque sensor 401 can provide a measured torque of the motor which drives the modeling material feed means which can be used as the measured parameter $P_M$ indicative of the pressure exerted on the modeling material 108 within the feed channel 120a, 120b of the tubular feed member 102. Alternatively, the motor current can be used as parameter $P_M$ indicative of the pressure exerted on the modeling material 108 within the feed channel 120a, 120b. The motor current is proportional to the torque delivered by the motor to the transmission 105a, 105b to the plunger 103. Moreover the plunger pressure can be used as parameter $P_M$ indicative of the pressure exerted on the modeling material 108. The control system 412 can be arranged to compare the measured parameter $P_M$ to a reference parameter value $P_R$, by means of a subtractor 403. The measured parameter $P_M$ is subtracted in the subtractor 403 from the reference parameter value $P_R$, which difference is supplied to the regulation function module 402 having a transfer function $H_2$. The transfer function $H_2$ can be proportional (P), proportional and integrating (PI), or proportional, integrating and differentiating (PID). The controller provided with a regulation module 402 controls the drive system 113.

By controlling the motor current, pressure control on the modeling material 108 within the tubular feed member 101 can be achieved.

The reference parameter value or setpoint $P_R$ may vary depending on printhead travel speed, gap size, temperature, modeling material properties.

In fig. 5 the system corresponding to the system of fig. 4a is shown having an alternative way for establishing the parameter indicative of the pressure exerted on the modeling material 108. In the system of fig 4a, the parameter is indicative of the pressure exerted on the modeling material within the printhead 121, i.e. the tubular feed member 101. In the system of fig. 5, the parameter indicative of the pressure exerted on the modeling material is determined by the pressure exerted on the modeling material being deposited in track 110 at the tip 102b of the nozzle 102. While extruding by exerting a pressure on the modeling material 108 in the printhead 121, a pressure at the nozzle tip 102b is caused within the deposited layer 110, which results in an force which pushes the nozzle tip 102b away from the previously deposited tracks 109.

This force is propagated from the printhead 121 via the gantry 106 and X-Y-Z positioning system 503 which is connected to the base 504 whereupon the object to be modeled is placed. Alternatively, the X-Y-Z-system and gantry may be connected to ground. Thus the object to be printed can be on ground which serves as a base for the object to be printed. The force exerted on the modeling material is then measurable between the object and the ground.

The force is thus also being propagated between the gantry 106 and the printhead 121 and can for example be measured at the connection 107. The connection 107 of the printhead 121 to the gantry 106 of fig. 4a can be formed by at least one resilient connection member 502. A displacement sensor 501 can measure the deformation of the resilient connection member 502 as a measure for the force transmitted through the propagation path from the printhead to the object to be created via the X-Y-Z system and base, and thereby the pressure exerted on the feed in the deposited track 110.

Alternatively, measurement of the force can also be achieved in a system according to fig. 4a, wherein the connection 107 between the printhead 121 and gantry 106 is provided with a load cell or strain gauge, which measure a pressure exerted by the printhead 121 and the track 110 being deposited.

Moreover, the force exerted on the modeling material in the layer 110 being deposited can be measured between the object and the base 504, by for example using a weight scale, or pressure pad. The force thus measured is indicative for the pressure exerted on the modeling material within the layer being deposited.

As shown in figures 6a - 6d, alternatively to measuring the pressure exerted on the modeling material within the printhead 121, as described in relation to figure 4a, i.e. the torque of the drive and transmission system or force at the plunger 103, a pressure exerted on the modeling material 108 within the tubular feed member 101, i.e. the feed channel 120a can be measured directly, as shown in fig. 6a. The pressure measured by the pressure sensor 601 can be used for controlling the drive 104 in order to obtain a pressure suitable for printing the modeling material into the track 110 to be deposited. An alternative placement of pressure sensor 602 is shown in fig. 6b, wherein the pressure sensor 602 is placed within the nozzle 102 and wherein the pressure is sensed of the feed channel 120b within the nozzle 102. An alternative for measuring the pressure within the feed channel 120b is to measure deformation of the nozzle around the feed channel 120b.

An alternative to measuring the pressure within the feed channel 120a, 120b, is to have a pressure sensor 604 as shown in fig. 6d, which is arranged within the nozzle 102 and which is fluidly connected to the nozzle tip 102. The pressure measured at the nozzle tip 102b represents the pressure exerted on the modeling material track 110. Thus this way an alternative way to for establishing a pressure exerted on the modeling material in track110 is established relative to fig. 5 is provided.

Pressure sensors suitable for use in an additive manufacturing system as described above for measuring pressure within the printhead 121, comprise membrane sensors which have a deformable membrane. A liquid such as mercury may transfer the pressure within the modeling material channel wherein pressure is to be measured, i.e. the feed channel 120a, 120b, or at the nozzle tip 102b to the membrane. The sensor itself may be of a type including a thin film metal sensor, a conductor/strain gauge related sensor, a piezo-electric sensor, magneto-resistive sensor, laser interferometer sensor and sensor based on mechanical displacement.

As shown in figures 6a - 6d, the track 110 can be deposited next to a previously deposited track 109 using pressure control forming a continuous track of deposited modeling material. The track 110 will by the pressure exerted on it via the nozzle orifice or nozzle tip flow to the previously deposited track and fuse with the previously deposited material. In figures 7a - 7c an alternative strategy is shown for deposition of tracks of modeling material using pressure control.

A first track 701 is deposited, using flow or pressure control as shown in fig. 7a. In fig. 7b a second track 702 is shown being deposited spaced apart from the first track 701. In fig. 7c a third track 703 is shown being printed between tracks 701 and 702 using pressure control. The modeling material 108 fills the open space between the first track 701 and the second track 702 and fuses with these previously deposited tracks, such that the tracks 701, 702 - 703 form a continuous layer without gaps or cavities. In figures 8a, 8b a refinement of the printing strategy is shown, wherein a first stack of tracks 801 is deposited using flow control. Adjacent tracks 802a, 802b having a more coarse deposition profile can be deposited using pressure control as an infill.

The control system may comprise a programmable logic controller (PLC), a microcontroller or processor having a memory (RAM, ROM, EPROM, etc) comprising program instructions, which in operation cause the processor to perform the controlling as described.

The program instruction may comprise modules for calculating pressures exerted on the modeling material 108 from these indicative forces and torques as described. Moreover losses due to friction and other causes within the drive, transmission, modeling material tubular feed member 101 and nozzle may be calculated and used to compensate or correct the control loops 412 as described.

The embodiments above are described as examples only. Supplements and modifications can be made to these embodiments without departing from the scope as defined set out in the claims below.

REFERENCE NUMERALS

| 100 | Additive manufacturing system |
| 101 | Tubular feed member |
| 102 | Nozzle |
| 102a | Nozzle outlet |
| 102b | Nozzle tip |
| 103 | Piston |
| 104 | Drive |
| 105a, 105b | Gear |
| 106 | Gantry |
| 107 | Connection bar |
| 108 | Modeling material |
| 109 | Previously deposited tracks |
| 110 | Deposited FDM track |
| 110a | New track of modeling material |
| 110b | Incompletely dispensed track of modeling material |
| 110c | Over-extruded track of modeling material |
| 110d | Track of modeling material deposited in tight fitting |
| 110e | Track of modeling material broader than the previously deposited tracks |
| 111 | Displacement sensor |
| 112 | Displacement control system |
| 113 | Drive system compensation |
| 114 | Flow regulator module |
| 120a, 120b | Feed channel |
| 121 | Printhead |
| 400 | Additive manufacturing system for pressure control within the printhead |
| 401 | Sensor for parameter indicative of pressure within feed channel |

| 402 | Pressure control module |
|---|---|
| 403 | Subtractor |
| 412 | Control system for pressure control |
| 500 | Additive manufacturing system for pressure control at nozzle tip |
| 501 | Displacement sensor |
| 502 | Resilient member |
| 503 | XYZ positioning system |
| 601 - 604 | Pressure sensor |
| 605 | First track |
| 606 | Third track |
| 607 | Second track |
| 701 | First track using flow control |
| 702 | Second track using flow control |
| 703 | Third track using pressure control |
| 801 | First stack of tracks |
| 802a-802b | Adjacent tracks |
| 'S' | Flow setpoint |
| 'X' | Displacement per time unit |
| PR | Pressure setpoint |
| PM | Measured parameter indicative of the pressure |
| 'H1' | Flow control transfer function |
| 'H2' | Pressure control transfer function |

Experimental

Parts have been prepared according to the method of the present invention, wherein the process comprises the steps of

a. exerting a pressure on the modeling material to feed the modeling material onto the predetermined positions;
b. determining a parameter indicative for the pressure exerted on the modeling material and
c. controlling the feeding depending on said parameter, and wherein providing each of the layers is performed by
d. printing contour lines of the object in the X-Y plane marking a primary area,
e. filling a first part of the primary area inside the contour lines of the object in the X, Y plane, leaving open a second part in the primary area
f. filling the second part by the depositing step.

Hereinafter, this process is called the BOND process.

*Porosity*

For the porosity test, test specimens printed of PEEK material were printed according to the BOND process, were compared to test specimens printed from Ultem 9085 with 100% infill on a Stratasys Fortus 450mc printer. Microscopic samples were examined and the images were processed according to the procedure 'Porosity test'. The results are shown in figure 12 and in the table 1 below:

Table 1

| | Sample | Material | Porosity |
|---|---|---|---|
| According to the invention | B01 | PEEK | 0.0% |
| | B02 | PEEK | 0.0% |
| | B03 | PEEK | 0.0% |
| | B04 | PEEK | 0.0% |
| | B05 | PEEK | 0.033% |
| | B06 | PEEK | 0.006% |
| | B07 | PEEK | 0.017% |

(continued)

|  | Sample | Material | Porosity |
|---|---|---|---|
|  |  |  |  |
| According to the prior art | S01 | Ultem | 13.3% |
|  | S02 | Ultem | 14.0% |
|  | S03 | Ultem | 13.6% |
|  | S04 | Ultem | 10.6% |
|  | S05 | Ultem | 13.1% |
|  | S06 | Ultem | 14.5% |
|  | S07 | Ultem | 15.4% |
|  | S08 | Ultem | 12.2% |
|  | S09 | Ultem | 17.8% |
|  | S10 | Ultem | 18.4% |
|  | S11 | Ultem | 10.8% |
|  | S12 | Ultem | 16.1 |
|  | S13 | Ultem | 19.0 |

*Leak tests*

Leak tests were carried out according to the leak test experiment described above. Different parts have been prepared from Ultem prepared on a state of the art Stratasys Fortus 450 mc machine with different thickness, varying from 1 to 2.5 mm. Also parts have been prepared from polycarbonate (prepared on the Stratasys machine) and ABS (prepared on an Ultimaker machine. Parts have been taken from the build plane of the part (XY direction).

4 parts have been prepared with varying thickness from PEEK, prepared according to the BOND process, which uses pressure controlled printing as described above. Parts have been prepared from the build plane (XY) and perpendicular to the build plane (Z-direction).

The results are summarized in table 2.

Table 2

| Machine brand | Machine type | Material | Result |
|---|---|---|---|
| Stratasys | Fortus 450mc | Ultem 9085 | too many bubbles to estimate flow |
| Stratasys | Fortus 450mc | PC | too many bubbles to estimate flow |
| Ultimaker | II | ABS | too many bubbles to estimate flow |
| Bond | Experimental setup | PEEK 450G | below detection limit; no bubbles |

In all samples prepared from Stratasys parts and Ultimaker parts, bubbles were found, so much that the flow could not be measured in the leak test. For all parts made according to the BOND process, no bubbles could be observed, meaning that all parts were leak tight.

Mechanical properties.

10 samples of PEEK were prepared according to the BOND process and the critical strength in the Z direction (perpendicular to the build plane) has been determined according to ISO 527-2:2012. Results are shown in table 3.

Table 3.

| Sample | Stress at break | Strain at break |
|---|---|---|
|  | [MPa] | [%] |
| 1231 | 93.925 | 5.246 |

(continued)

| Sample | Stress at break | Strain at break |
|--------|-----------------|-----------------|
|        | [MPa]           | [%]             |
| 1234   | 95.829          | 5.174           |
| 892    | 102.326         | 9.105           |
| 889    | 89.496          | 6.157           |
| 888    | 92.603          | 5.858           |
| 901    | 101.338         | 6.889           |
| 914    | 104.186         | 7.604           |
| 912    | 101.036         | 6.833           |
| 908    | 100.115         | 6.616           |
| 905    | 100.864         | 7.787           |

3 samples have been prepared from Ultem on a Stratasys machine. Strength at break according to prior art has been determined and is shown in table 4.

**Stratasys Ultem**

Table 4.

|          | $\Sigma X$ (MPa) | $\Sigma Y$ (MPa) | $\Sigma Z$ (MPa) |
|----------|-------------------|-------------------|-------------------|
| Sample 1 | 74.73             | 61.24             | 42.03             |
| Sample 2 | 62.65             | 60.88             | 43.55             |
| Sample 3 | 68.36             | 53.43             | 41.78             |
|          |                   |                   |                   |
| Average  | 68.6              | 58.5              | 42.5              |
| Best     | 74.7              | 61.2              | 43.6              |

Testbars have been prepared with a FDM process on Ultimaker, Stratasys equipment and the according to the BOND process. Parts have been prepared from different thermoplastic materials and properties have been determined as shown in table 5.

Table 5.

| Manufacturer<br>Technology<br>*Material* | Ultimaker<br>FDM<br>*ABS* | Stratasys<br>FDM<br>*PC* | Stratasys<br>FDM<br>*Ultem* | Bond<br>FDM<br>*PEEK* |
|------------------------------------------|---------------------------|--------------------------|------------------------------|------------------------|
| 1. Porosity                              | >10%                      | >10%                     | >10%                         | <0.05%                 |
| 2. Leak tight                            | No                        | no                       | no                           | Yes                    |
| 3. Lowest strength                       | 30 MPa                    | 35 MPa                   | 43 MPa                       | >89 MPa                |
| 4. Strength isotropy                     | 90%                       | 61%                      | 62%                          | >90                    |
| 5. Lowest strain                         | 1.8%                      | 2.8%                     | 3.8%                         | 5-9%                   |
| 6. Strain isotropy                       | 34%                       | 58%                      | 70%                          |                        |

The data show that the Bond parts show no porosity and are leak tight. The parts made in conventional machines are not leaktight and show a lot of cavities due to under-extrusion.

The BOND process is capable of printing parts of more demanding thermoplastic materials than the parts made on prior art machines. PEEK is very difficult to use in an FDM process because of the polymer characteristics and cannot be printed on an Ultimaker or Stratasys machine.

## Claims

1. A three-dimensional object created by Fused Deposition Modeling, FDM, of a modeling material from polyaryletherketones (PAEK), polyphenylsulfides, polyamide-imide, polyethersulfon, polyetherimide, polysulfon, polyphenylsulfon, polycarbonates (PC), poly(acrylonitrile butadiene styrene) (ABS), polymethylmethacrylate (PMMA), polyethyleneterephtalate (PET), polystryrene (PS), acrylonitrilstyrene acrylate, polypropylene (PP), polylactic acid (PLA), polyvinylalcohol (PVA), polyethylene (PE), polyoxymethylene, polyurethane (PU), copolymers of polyvinylalcohol and butenediolvinylalcohol and mixtures thereof, optionally filled with inorganic or organic fillers, **characterized in that** the object has a porosity of less than 5 vol%, as determined according to the porosity test procedure 'Porosity test' as defined in the description.

2. The object according to claim 1, wherein the porosity is less than 1 vol%, preferably less than 0.5 vol%, even less than 0.2 vol%, less than 0.1 vol% or even less than 0.01 vol%.

3. The object according to claims 1 or 2, wherein the object has a leak tightness below $10 \times 10^{-6}$ mbar·l/s, preferably below $4.3 \times 10^{-6}$ mbar·l/s, more preferably between 0 and $3 \times 10^{-6}$ mbar·l/s, as determined by the leak test procedure defined in the description.

4. The object according to any one of claims 1-3, wherein the ultimate tensile strength of a test piece measured in the Z-direction is at least 70% of the ultimate tensile strength of the test piece measured in the X-direction or Y-direction, wherein the ultimate tensile strength is measured according to ISO 527-2:2012 SPECIMEN 5A.

5. The object according to any one of claims 1-4, wherein object is prepared from a thermoplastic composition using FDM, and wherein the thermoplastic polymer is chosen from polyethylene, polypropylene, ABS, polycarbonate and polyarylether ketones (PAEK) like for example polyether ketone (PEK), polyethyer ethyer ketone (PEEK), polyether ketone ketone (PEKK), polyether ether ketone ketone (PEEKK) and polyether ether ketone ether ketone ketone (PEKEKK) and combinations thereof.

6. The object according to any one of claims 1-5, wherein the thermoplastic polymer composition comprises at least 80 wt% of a PAEK, preferably at least 90 wt% of a PAEK.

7. The object according to any one of claims 1-6, wherein the thermoplastic polymer composition comprises at least 80 wt% of PEEK, preferably at least 90 wt% of a PEEK, more preferably PEEK.

8. The object according to any one of claims 6-7, wherein a test specimen of the object having dimensions according to ISO 527-2:2012 SPECIMEN 5A made from said polymer composition by said additive manufacturing has an ultimate tensile stress according to ISO 527-2:2012 SPECIMEN 5A of at least 70 MPa, preferably 80 MPa , more preferably 90 MPa.

9. The object according to any one of the preceding claims, wherein the FDM is performed by providing a layer in an X-Y plane having X-direction and Y-direction and successively adding further layers on top of said layer in Z-direction by depositing a modeling material onto predetermined positions, wherein X-direction, Y-direction and Z-direction are perpendicular to each other, wherein the depositing step involves

   a. exerting a pressure on the modeling material to feed the modeling material onto the predetermined positions;
   b. determining a parameter indicative for the pressure exerted on the modeling material and
   c. controlling the feeding depending on said parameter.

10. The object according to claim 9, wherein providing of each of the layers is performed by

    d. printing contour lines of the object in the X-Y plane marking a primary area,
    e. filling a first part of the primary area inside the contour lines of the object in the X, Y plane, leaving open a second part in the primary area,

f. filling the second part by the depositing step.

11. The object according to claim 10, wherein filling of the first part is performed by feeding the modeling material onto the predetermined positions in a flow-controlled way.

12. An object created by Fused Deposition Modeling, FDM, from a thermoplastic composition comprising at least 80 wt% of a polyarylether keton (PAEK), **characterized in that**

a test specimen of the object having dimensions according to ISO 527-2:2012 SPECIMEN 5A made from said polymer composition by said additive manufacturing has an ultimate tensile stress according to ISO 527-2:2012 SPECIMEN 5A of at least 70 MPa in the X, Y and Z direction, preferably at least 80 MPa , more preferably at least 90 MPa.

13. The object according to claim 12, wherein the FDM is performed by providing a layer in an X-Y plane having X-direction and Y-direction and successively adding further layers on top of said layer in Z-direction by depositing a modeling material onto predetermined positions, wherein X-direction, Y-direction and Z-direction are perpendicular to each other, wherein the depositing step involves

a. exerting a pressure on the modeling material to feed the modeling material onto the predetermined positions;

b. determining a parameter indicative for the pressure exerted on the modeling material and

c. controlling the feeding depending on said parameter.

and wherein providing of each of the layers is performed by

d. printing contour lines of the object in the X-Y plane marking a primary area,

e. filling a first part of the primary area inside the contour lines of the object in the X, Y plane, leaving open a second part in the primary area,

f. filling the second part by the depositing step.

14. The object according to any one of claims 12-13, wherein the thermoplastic composition comprises at least 90 wt% PEEK.

## Patentansprüche

1. Dreidimensionales Objekt, das durch Schmelzschichtung, FDM, eines Modelliermaterials aus Polyaryletherketonen (PAEK), Polyphenylsulfiden, Polyamidimid, Polyethersulfon, Polyetherimid, Polysulfon, Polyphenylsulfon, Polycarbonaten (PC), Poly(acrylnitrilbutadienstyrol) (ABS), Polymethylmethacrylat (PMMA), Polyethylenterephtalat (PET), Polystyrol (PS), Acrylnitrilstyrolacrylat, Polypropylen (PP), Polymilchsäure (PLA), Polyvinylalkohol (PVA), Polyethylen (PE), Polyoxymethylen, Polyurethan (PU), Copolymeren von Polyvinylalkohol und Butendiolvinylalkohol und Mischungen davon, optional mit anorganischen oder organischen Füllstoffen gefüllt, erzeugt wird, **dadurch gekennzeichnet, dass** das Objekt eine Porosität von weniger als 5 Vol.-% aufweist, wie gemäß dem Porositätsprüfverfahren "Porositätsprüfung"', wie in der Beschreibung definiert, bestimmt.

2. Objekt nach Anspruch 1, wobei die Porosität weniger als 1 Vol.-%, vorzugsweise weniger als 0,5 Vol.-%, sogar weniger als 0,2 Vol.-%, weniger als 0,1 Vol.-% oder sogar weniger als 0,01 Vol.-% beträgt.

3. Objekt nach Ansprüchen 1 oder 2, wobei das Objekt eine Dichtigkeit unter $10 \times 10^{-6}$ mbar l/s, vorzugsweise unter $4,3 \times 10^{-6}$ mbar l/s, mehr bevorzugt zwischen 0 und $3 \times 10^{-6}$ mbar l/s aufweist, wie durch das in der Beschreibung definierte Dichtheitsprüfverfahren bestimmt.

4. Objekt nach einem der Ansprüche 1 bis 3, wobei die Zugfestigkeit eines in der Z-Richtung gemessenen Prüfstücks mindestens 70 % der Zugfestigkeit des in der X- oder Y-Richtung gemessenen Prüfstücks beträgt, wobei die Bruchzugfestigkeit gemäß ISO 527-2:2012 SPECIMEN 5A gemessen wird.

5. Objekt nach einem der Ansprüche 1 bis 4, wobei das Objekt aus einer thermoplastischen Zusammensetzung unter Verwendung von FDM hergestellt ist und wobei das thermoplastische Polymer aus Polyethylen, Polypropylen, ABS, Polycarbonat und Polyaryletherketonen (PAEK) wie zum Beispiel Polyetherketon (PEK), Polyetheretherketon (PEEK), Polyetherketonketon (PEKK), Polyetheretherketonketon (PEEKK) und Polyetheretherketonetherketonketon (PEKEKK) und Kombinationen davon ausgewählt ist.

6. Objekt nach einem der Ansprüche 1 bis 5, wobei die thermoplastische Polymerzusammensetzung zu mindestens 80 Gew.-% ein PAEK, vorzugsweise zu mindestens 90 Gew.-% ein PAEK umfasst.

7. Objekt nach einem der Ansprüche 1 bis 6, wobei die thermoplastische Polymerzusammensetzung zu mindestens 80 Gew.-% PEEK, vorzugsweise zu mindestens 90 Gew.-% ein PEEK, mehr bevorzugt PEEK umfasst.

8. Objekt nach einem der Ansprüche 6 bis 7, wobei ein Prüfkörper des Objekts, der Abmessungen gemäß ISO 527-2:2012 SPECIMEN 5A aufweist, gefertigt aus der Polymerzusammensetzung durch additive Fertigung, eine Zerreißbeanspruchung gemäß ISO 527-2:2012 SPECIMEN 5A von mindestens 70 MPa, vorzugsweise 80 MPa, mehr bevorzugt 90 MPa aufweist.

9. Objekt nach einem der vorstehenden Ansprüche, wobei die FDM durch Bereitstellen einer Schicht in einer X-Y-Ebene, die die X- und Y-Richtung aufweist, und aufeinanderfolgendes Hinzufügen weiterer Schichten oben auf der Schicht in Z-Richtung durch Abscheiden eines Modelliermaterials auf vorbestimmte Positionen durchgeführt wird, wobei die X-Richtung, Y-Richtung und Z-Richtung senkrecht zueinander sind, wobei der Abscheidungsschritt beinhaltet:

   a. Ausüben eines Drucks auf das Modelliermaterial, um den vorbestimmten Positionen das Modelliermaterial zuzuführen;
   b. Bestimmen eines Parameters, der den Druck angibt, der auf das Modelliermaterial ausgeübt wird, und
   c. Steuern der Zuführung in Abhängigkeit von dem Parameter.

10. Objekt nach Anspruch 9, wobei das Bereitstellen jeder der Schichten durchgeführt wird durch

   d. Drucken von Konturlinien des Objekts in der X-Y-Ebene, wobei ein primärer Bereich markiert wird,
   e. Füllen eines ersten Teils des primären Bereichs innerhalb der Konturlinien des Objekts in der X-, Y-Ebene, wobei ein zweiter Teil in dem primären Bereich offen bleibt,
   f. Füllen des zweiten Teils durch den Abscheidungsschritt.

11. Objekt nach Anspruch 10, wobei das Füllen des ersten Teils durch Zuführen des Modelliermaterials auf die vorbestimmten Positionen in einer durchflussgesteuerten Weise durchgeführt wird.

12. Objekt, das durch Schmelzschichtung, FDM, aus einer thermoplastischen Zusammensetzung erzeugt wird, die zu mindestens 80 Gew.-% ein Polyaryletherketon (PAEK) umfasst, **dadurch gekennzeichnet, dass** ein Prüfkörper des Objekts, der Abmessungen gemäß ISO 527-2:2012 SPECIMEN 5A aufweist, gefertigt aus der Polymerzusammensetzung durch die additive Fertigung, eine Zerreißbeanspruchung gemäß ISO 527-2:2012 SPECIMEN 5A von mindestens 70 MPa in der X-, Y- und Z-Richtung, vorzugsweise mindestens 80 MPa, mehr bevorzugt mindestens 90 MPa aufweist.

13. Objekt nach Anspruch 12, wobei die FDM durch Bereitstellen einer Schicht in einer X-Y-Ebene, die die X- und Y-Richtung aufweist, und aufeinanderfolgendes Hinzufügen weiterer Schichten oben auf der Schicht in Z-Richtung durch Abscheiden eines Modelliermaterials auf vorbestimmte Positionen durchgeführt wird, wobei die X-Richtung, Y-Richtung und Z-Richtung senkrecht zueinander sind, wobei der Abscheidungsschritt beinhaltet:

   a. Ausüben eines Drucks auf das Modelliermaterial, um den vorbestimmten Positionen das Modelliermaterial zuzuführen;
   b. Bestimmen eines Parameters, der den Druck angibt, der auf das Modelliermaterial ausgeübt wird, und
   c. Steuern der Zuführung in Abhängigkeit von dem Parameter.
   und wobei das Bereitstellen jeder der Schichten durchgeführt wird durch
   d. Drucken von Konturlinien des Objekts in der X-Y-Ebene, wobei ein primärer Bereich markiert wird,
   e. Füllen eines ersten Teils des primären Bereichs innerhalb der Konturlinien des Objekts in der X-, Y-Ebene, wobei ein zweiter Teil in dem primären Bereich offen bleibt,
   f. Füllen des zweiten Teils durch den Abscheidungsschritt.

14. Objekt nach einem der Ansprüche 12 bis 13, wobei die thermoplastische Zusammensetzung zu mindestens 90 Gew.-% PEEK umfasst.

**Revendications**

1. Objet tridimensionnel créé par un dépôt de fil fondu, DFF, d'un matériau de modélisation à partir de polyaryléthercétones (PAEK), polyphénylsulfures, polyamide-imide, polyéthersulfone, polyétherimide, polysulfone, polyphénylsulfone, polycarbonates (PC), poly(acrylonitrile butadiène styrène) (ABS), polyméthacrylate de méthyle (PMMA), polytéréphtalate d'éthylène (PET), polystyrène (PS), acrylonitrile styrène acrylate, polypropylène (PP), acide polylactique (PLA), alcool polyvinylique (PVAL), polyéthylène (PE), polyoxyméthylène, polyuréthane (PU), copolymères de polyalcool de vinyle et alcool de butènediol vinylique et de leurs mélanges, éventuellement remplis de charges minérales ou organiques,
**caractérisé en ce que** l'objet a une porosité inférieure à 5 % en volume, telle que déterminée selon le procédé de test de porosité « test de porosité », tel que défini dans la description.

2. Objet selon la revendication 1, dans lequel la porosité est inférieure à 1 % en volume, de préférence inférieure à 0,5 % en volume, même inférieure à 0,2 % en volume, inférieure à 0,1 % en volume ou même inférieure à 0,01 % en volume.

3. Objet selon la revendication 1 ou 2, dans lequel l'objet présente une étanchéité inférieure à $10 \times 10^{-6}$ mbar l/s, de préférence inférieure à $4,3 \times 10^{-6}$ mbar l/s, plus préférablement entre 0 et $3 \times 10^{-6}$ mbar l/s, tel que déterminé par la procédure de test d'étanchéité définie dans la description.

4. Objet selon l'une quelconque des revendications 1 à 3, dans lequel la résistance limite à la rupture d'une pièce d'essai mesurée dans la direction Z est d'au moins 70 % de la résistance limite à la rupture de la pièce d'essai mesurée dans la direction X ou dans la direction Y, dans laquelle la résistance limite à la rupture est mesurée selon la norme ISO 527-2:2012 SPECIMEN 5A.

5. Objet selon l'une quelconque des revendications 1 à 4, dans lequel l'objet est préparé à partir d'une composition thermoplastique à l'aide de DFF, et dans lequel le polymère thermoplastique est choisi parmi le polyéthylène, le polypropylène, l'ABS, le polycarbonate et les polyaryléthercétones (PAEK) comme par exemple le polyéthercétone (PEK), le polyétheréthercétone (PEEK), le polyéthercétonecétone (PEKK), le polyétheréthercétonecétone (PEEKK) et le polyétheréthercétoneéthercétonecétone (PEKEKK) et leurs combinaisons.

6. Objet selon l'une quelconque des revendications 1 à 5, dans lequel la composition de polymère thermoplastique comprend au moins 80 % en poids d'un PAEK, de préférence au moins 90 % en poids d'un PAEK.

7. Objet selon l'une quelconque des revendications 1 à 6, dans lequel la composition de polymère thermoplastique comprend au moins 80 % en poids de PEEK, de préférence au moins 90 % en poids d'un PEEK, plus préférablement en PEEK.

8. Objet selon l'une quelconque des revendications 6 à 7, dans lequel un spécimen d'essai de l'objet ayant des dimensions selon ISO 527-2:2012 SPECIMEN 5A fabriqué à partir de ladite composition polymère par ladite fabrication additive présente une résistance limite à la rupture selon ISO 527-2:2012 SPECIMEN 5A d'au moins 70 MPa, de préférence 80 MPa, plus préférablement 90 MPa.

9. Objet selon l'une quelconque des revendications précédentes, dans lequel le DFF est effectué par la fourniture d'une couche dans un plan X-Y ayant une direction X et une direction Y et par l'ajout successivement de couches supplémentaires au-dessus de ladite couche dans la direction Z par le dépôt d'un matériau de modélisation sur des positions prédéterminées, dans lequel la direction X, la direction Y et la direction Z sont perpendiculaires l'une à l'autre, dans lequel l'étape de dépôt implique

   a. l'exercice d'une pression sur le matériau de modélisation pour alimenter le matériau de modélisation sur les positions prédéterminées ;
   b. la détermination d'un paramètre indicatif de la pression exercée sur le matériau de modélisation et
   c. la commande de l'alimentation en fonction dudit paramètre.

10. Objet selon la revendication 9, dans lequel la fourniture de chacune des couches est effectuée par

   d. l'impression de lignes de contour de l'objet dans le plan X-Y marquant une zone principale,
   e. le remplissage d'une première partie de la zone principale à l'intérieur des lignes de contour de l'objet dans le plan X, Y, laissant ouverte une deuxième partie dans la zone principale,
f. le remplissage de la seconde pièce par l'étape de dépôt.

11. Objet selon la revendication 10, dans lequel le remplissage de la première partie est effectué par l'alimentation du matériau de modélisation sur les positions prédéterminées en mode à flux contrôlé.

12. Objet créé par un dépôt de fil fondu, DFF, à partir d'une composition thermoplastique comprenant au moins 80 % en poids d'un polyaryléthercétone (PAEK), **caractérisé en ce qu'** un spécimen d'essai de l'objet ayant des dimensions selon ISO 527- 2:2012 SPECIMEN 5A fabriqué à partir de ladite composition polymère par ladite fabrication additive présente une résistance limite à la rupture selon ISO 527-2:2012 SPECIMEN 5A d'au moins 70 MPa dans la direction X, Y et Z, de préférence d'au moins 80 MPa, plus préférentiellement d'au moins 90 MPa.

13. Objet selon la revendication 12, dans lequel le DFF est effectué par la fourniture d'une couche dans un plan X-Y ayant une direction X et une direction Y et par l'ajout successivement de couches supplémentaires au-dessus de ladite couche dans la direction Z par le dépôt d'un matériau de modélisation sur des positions prédéterminées, dans lequel la direction X, la direction Y et la direction Z sont perpendiculaires l'une à l'autre, dans lequel l'étape de dépôt implique

a. l'exercice d'une pression sur le matériau de modélisation pour alimenter le matériau de modélisation sur les positions prédéterminées
b. la détermination d'un paramètre indicatif de la pression exercée sur le matériau de modélisation et
c. la commande de l'alimentation en fonction dudit paramètre.
et dans lequel la fourniture de chacune des couches est effectuée par
d. l'impression de lignes de contour de l'objet dans le plan X-Y marquant une zone principale,
e. le remplissage d'une première partie de la zone principale à l'intérieur des lignes de contour de l'objet dans le plan X, Y, laissant ouverte une deuxième partie dans la zone principale,
f. le remplissage de la seconde pièce par l'étape de dépôt.

14. Objet selon l'une quelconque des revendications 12 à 13, dans lequel la composition thermoplastique comprend au moins 90 % en poids de PEEK.

Fig. 1a

(State of the art)

Fig. 1b

(State of the art)

Fig. 2a
(State of the art)

Fig. 2b
(State of the art)

Fig. 2c
(State of the art)

Fig. 3a

Fig. 3b

Fig. 4a

Fig. 4b

Fig. 5

Fig. 6a

Fig. 6b

Fig. 6c

Fig. 6d

Fig. 7a

Fig. 7b

Fig. 7c

Fig. 8a

Fig. 8b

XY

Print head

Sample type 'A'
Build plate

Z

XY

Print head

Sample type 'B'

Z          Build plate

Sample type 'C'

Larger object

Fig. 9

Cross section A-A

Alignment pins

B                    B

Cross section B-B

20x20
ø16
ø12

A                                  A
2

Test setup, top
Water
Tested sample
Detail 'C'
Test setup, bottom
Compressed air

Detail C

Air leaking
through sample

Air bubbles

Air leaking
past the seal

Fig. 10

Fig. 11a

Fig. 11b

Fig. 11c

Fig. 11d

Fig. 11e

Fig. 11f

**Porosity as determined by the algorithm [%]**

| | | 0% | 2% | 4% | 6% | 8% | 10% | 12% | 14% | 16% | 18% | 20% |
|---|---|---|---|---|---|---|---|---|---|---|---|---|
| **Samples according to the invention** | B01 | 0.0% | | | | | | | | | | |
| | B02 | 0.0% | | | | | | | | | | |
| | B03 | 0.0% | | | | | | | | | | |
| | B04 | 0.0% | | | | | | | | | | |
| **Samples printed with prior art technology** | S01 | | | | | | | | 13.3% | | | |
| | S02 | | | | | | | | 14.0% | | | |
| | S03 | | | | | | | | 13.6% | | | |
| | S04 | | | | | | | 10.6% | | | | |
| | S05 | | | | | | | | 13.1% | | | |
| | S06 | | | | | | | | 14.5% | | | |
| | S07 | | | | | | | | | 15.4% | | |
| | S08 | | | | | | | 12.2% | | | | |
| | S09 | | | | | | | | | | 17.8% | |
| | S10 | | | | | | | | | | 18.4% | |
| | S11 | | | | | | | 10.8% | | | | |

Fig. 12

Fig. 13

Fig. 14

Fig. 15

Fig. 16

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20140141166 A

- WO 2015193819 A